# EUROPÄISCHE PATENTANMELDUNG

(11) **EP 2 431 750 A2**
(43) Veröffentlichungstag der Anmeldung: **21.03.2012**
(21) Anmeldenummer: 11007543.9
(22) Anmeldetag: 15.09.2011
(51) Int. Cl.: G01R 1/04

(54) **Vorrichtung zur Überwachung von Strömen**

(30) Priorität: 18.09.2010 DE 102010045973
(71) Anmelder: Common-Link AG, 76189 Karlsruhe (DE)
(72) Erfinder: Schläfer, Wolfgang, 76773 Kuhardt (DE)
(74) Vertreter: Dimmerling, Heinz

(57) **Zusammenfassung**

Eine Vorrichtung zur Überwachung von in Anschlussleitungen eingespeisten Strömen, insbesondere zur Überwachung von Generatorströmen, insbesondere von Photovoltaikanlagen, mit Anschlussklemmen (7), an welche die Anschlussleitungen anklemmbar sind, und welche über Stromsensoren (19a, 19a', 19b, 19b'), welche einen Stromeingang und einen Stromausgang für den zu überwachenden Strom haben, mit einer Sammelschiene (1) verbunden sind, ist dadurch gekennzeichnet, dass die Anschlussklemmen (7) auf einer Leiterplatte (6) angeordnet sind, auf welcher die Stromsensoren (19a, 19a', 19b, 19b') sowie Kontaktstifte (5) angeordnet sind, welche einerseits mit der Sammelschiene (1) und andererseits mit den Stromausgängen der Stromsensoren (19a, 19a', 19b, 19b') verbunden sind, wobei die Stromeingänge der Stromsensoren (19a, 19a', 19b, 19b') über wenigstens einen ersten auf der Leiterplatte (6) angeordneten Leiter (20a, 20b, 20c, 20d) mit den Anschlussklemmen (7) verbunden sind und die Verbindung der Stromausgänge der Stromsensoren (19a, 19a', 19b, 19b') mit den Kontaktstiften (5) über wenigstens einen zweiten auf der Leiterplatte (6) angeordneten Leiter erfolgt.

## Beschreibung

Die Erfindung betrifft eine Vorrichtung nach dem Oberbegriff des Anspruchs 1, zur Überwachung von in Anschlussleitungen eingespeisten Strömen, insbesondere zur Überwachung von Generatorströmen, insbesondere von Photovoltaikanlagen, oder zu einem Batteriemanagement, mit Anschlussklemmen, an welche die Anschlussleitungen anklemmbar sind, und welche über Stromsensoren, welche einen Stromeingang und -ausgang für den zu überwachenden Strom haben, mit einer Sammelschiene verbunden sind.

Eine derartige Vorrichtung ist im Stand der Technik hinreichend bekannt und wird überwiegend zur Erfassung der von einer Photovoltaikanlage abgegebenen Leistung verwendet. Die bekannte Vorrichtung besteht aus Einzelelementen, welche vor Ort von einem Monteur zusammengebaut werden müssen. Hierbei werden die Anschlussleitungen, die jeweils mit einem Ende mit einem aus mehreren hintereinander geschalteten Solarzellen gebildeten so genannten Strang verbunden sind, mit ihren anderen Enden jeweils mit einem Stromsensor, der auf einer Leiterplatte angeordnet ist, verbunden. Das andere Ende des Stromsensors ist mit einem ebenfalls auf der Leiterplatte angeordneten Kontaktblock befestigt. Die Kontaktblöcke weisen Bohrungen auf, mittels welcher eine aus einem elektrisch leitenden Material bestehende Sammelschiene auf die Kontaktblöcke befestigt wird. Von der Sammelschiene lässt sich somit der von den betreffenden Strängen gelieferte Strom abnehmen.

Wenngleich die Anordnung der Stromsensoren sowie der Kontaktblöcke auf der Leiterplatte und die Parallelschaltung der Kontaktblöcke mittels der Sammelschiene dem betreffenden Monteur den Aufbau der Vorrichtung auch erleichtert, so ist der Aufbau dennoch umständlich und zeitaufwendig. Des Weiteren müssen umfangreiche Isolierungsmaßnahmen vorgenommen werden, da die Sammelschiene auf einem Potential von mehr als 1.000 Volt liegen kann. Darüber hinaus ist die Vorrichtung nicht sehr robust und damit störanfällig. Außerdem sind weitere Maßnahmen zu treffen, die verhindern, dass sich Schnecken, Insekten und andere Tiere oder Pflanzen dem Aufbau nähern.

Es ist Aufgabe der Erfindung eine Eingangs genannte Vorrichtung derart auszubilden, dass sie einen robusteren Aufbau hat und auf einfache Weise einsetzbar ist.

Die Lösung dieser Aufgabe ergibt sich aus den Merkmalen des kennzeichnenden Teils des Anspruchs 1. Vorteilhafte Weiterbildungen der Erfindung ergeben sich aus den Unteransprüchen.

Gemäß der Erfindung ist eine Vorrichtung zur Überwachung von in Anschlussleitungen eingespeisten Strömen, insbesondere zur Überwachung von Generatorströmen, insbesondere von Photovoltaikanlagen, mit Anschlussklemmen, an welche die Anschlussleitungen anklemmbar sind, und welche über Stromsensoren, welche einen Stromeingang und einen Stromausgang für den zu überwachenden Strom haben, mit einer Sammelschiene verbunden sind, dadurch gekennzeichnet, dass die Anschlussklemmen auf einer Leiterplatte angeordnet sind, auf welcher die Stromsensoren sowie Kontaktstifte angeordnet sind, welche einerseits mit der Sammelschiene und andererseits mit den Stromausgängen der Stromsensoren verbunden sind, wobei die Stromeingänge der Stromsensoren jeweils über wenigstens einen ersten auf der Leiterplatte angeordneten Leiter, welcher vorzugsweise als Leiterbahn ausgebildet ist, mit den Anschlussklemmen verbunden sind und die Verbindung der Stromausgänge der Stromsensoren mit den Kontaktstiften jeweils über wenigstens einen zweiten auf der Leiterplatte angeordneten Leiter, welcher vorzugsweise als Leiterbahn ausgebildet ist, erfolgt.

Dadurch, dass die Anschlussklemmen sowie die Stromsensoren auf einer Leiterplatte angeordnet sind und auf der Leiterplatte Kontaktstifte vorhanden sind, welche mit der Sammelschiene verbunden sind, ergibt sich eine relativ stabile und kompakte Einheit, welche sehr gut handhabbar ist. Die Anschlussleitungen müssen lediglich noch mit den Anschlussklemmen verbunden werden, was einfach geht, da die Anschlussklemmen fest auf der Leiterplatte angeordnet sind. Die Verbindung der Anschlussklemmen mit den Stromsensoren und weiter mit der Sammelschiene ist bereits vorhanden, sodass ein entsprechender Verdrahtungsaufwand entfällt. Des Weiteren lassen sich die Stromsensoren geschützt anbringen, wodurch die Gefahr einer Beschädigung gering ist. Wegen der festen Anordnung der Anschlussklemmen sowie der Stromsensoren auf der Leiterplatte als auch der festen Verbindung der Leiterplatte mit der Sammelschiene lassen sich Isolierungsmaßnahmen bereits vor dem Einsatz der Vorrichtung vornehmen. Vor Ort ist es nicht mehr erforderlich, wesentliche Maßnahmen zur Isolierung vorzunehmen. Dies wirkt sich sehr vorteilhaft auf die Montagezeit aus.

Es hat sich als vorteilhaft erwiesen, die Leiterplatte als eine Multilayer-Leiterplatte auszubilden und für den ersten und/oder zweiten Leiter mehrere Schichten der Multilayer-Leiterplatte zu verwenden. Hierdurch ergibt sich ein geringer Leitungswiderstand, was sich sehr vorteilhaft auf die Verlustleistung der Vorrichtung auswirkt.

Als besonders vorteilhaft hat sich eine Ausführungsform der Erfindung herausgestellt, bei der die Kontaktstifte in Verbindungsöffnungen eingepresst sind, die in der Sammelschiene ausgebildet sind. Hierdurch wird neben der elektrischen Verbindung mit der Sammelschiene auf einfache Weise noch eine sehr gute mechanische Verbindung der Leiterplatte mit der Sammelschiene erreicht. Durch die Pressverbindung der Kontaktstifte mit der Sammelschiene sind im Wesentlichen keine weiteren Maßnahmen zur Verbindung der Leiterplatte mit der Sammelschiene erforderlich. Bei Bedarf ist es sogar möglich, dass die Kontaktstifte bei ihrer Montage von der Rückseite der Leiterplatte her durch diese hindurch in die Verbindungsöffnungen der Sammelschiene eingepresst werden.

Bei einer anderen Ausgestaltung der Erfindung ist der mindestens eine auf der Leiterplatte angeordnete Kontaktstift einstückig mit einem Kontaktabschnitt verbunden, wobei der Kontaktabschnitt mit der Sammelschiene verschraubt ist. Auch durch diese Maßnahme kann eine gute und dauerhafte Verbindung zwischen den Kontaktstiften und der Sammelschiene erreicht werden. Der Kontaktabschnitt kann eine Lochung der Sammelschiene durchsetzenden und an seinem freien Ende mittels einer Mutter mit der Sammelschiene verschraubt sein. Dabei kann die Sammelschiene zwischen der Mutter und einer an dem Kontaktabschnitt angeordneten Widerlagerstelle eingespannt sein. Es ist aber auch möglich, dass der Kontaktabschnitt mit einer die Sammelschiene durchsetzenden Schraube verschraubt ist, wobei die Sammelschiene zwischen dem Kontaktabschnitt und dem Kopf der Schraubenkopf eingespannt ist.

Sehr vorteilhaft ist es, wenn die Kontaktstifte sich aus einem insbesondere quaderförmigen Metallblock erstrecken. Hierdurch lässt sich eine sehr gute und robuste mechanische Verbindung der Kontaktstifte mit der Leiterplatte erreichen. Der Metallblock, aus dem die Kontaktstifte vorzugsweise herausgefräst sind, gibt den Kontaktstiften einen sehr guten Halt. Des Weiteren lassen sich die Kontaktstifte auf einfache Weise in auf der Leiterplatte ausgebildete korrespondierende Öffnungen einbringen. Die Öffnungen auf der Leiterplatte und die Kontaktstifte haben Abmessungen, dass die Kontaktstifte mit der Leiterplatte eine Pressverbindung bilden. Durch die Pressverbindung ergibt sich auch eine sehr gute Verbindung der Kontaktstifte mit der Multilayer-Leiterplatte.

Bei einer weiteren besonderen Ausführungsform der Erfindung ist vorgesehen, dass jeweils zwei Stromsensoren parallel geschaltet sind. Hierdurch wird in vorteilhafter Weise erreicht, dass die Vorrichtung bei Ausfall eines Stromsensors noch funktionstüchtig bleibt und der Ausfall des Sensors erkannt wird. Sind die Stromsensoren in vorteilhafter Weise als Shunt ausgebildet, verringert sich zwar durch die Parallelschaltung das Sensorsignal, jedoch lässt sich auf einfache Weise erkennen, wenn ein Shunt defekt ist. Denn dann ist das Sensorsignal größer als es sein müsste beziehungsweise zu erwarten wäre. Es verdoppelt sich. Die Parallelschaltung mehrerer, als Shunt ausgebildeter Stromsensoren hat außerdem den Vorteil, dass sich die Fläche, über welche die beim Stromfluss in den Stromsensoren auftretende Verlustwärme abgeführt wird, vergrößert.

Als vorteilhaft hat sich eine Ausführungsform erwiesen, bei der die Sammelschiene Ausnehmungen aufweist, in die sich die Stromsensoren erstrecken. Hierdurch lassen sich die Stromsensoren auf einfache Weise mit den ersten und zweiten Leitern verbinden, da die Ausnehmungen an einer geographisch günstigen Stelle ausgebildet werden können. Des Weiteren sind sie geschützt angeordnet, wodurch Beschädigungen vermieden werden können.

Bei einer weiteren besonderen Ausführungsform der Erfindung ist vorgesehen, dass der Metallblock sowie die Sammelschiene miteinander korrespondierende Durchgangsöffnungen aufweisen, durch welche eine Schraube durchführbar ist, mittels der ein Isolator oder ein Kühlkörper auf den Metallblock befestigbar ist. Wird die Schraube an der der Leiterplatte abgewandten Seite durch die Sammelschiene geführt, lässt sich der Isolator beziehungsweise der Kühlkörper mittels der Schraube auf den Metallblock pressen.

In vorteilhafter Weise ist der Kühlkörper mittels eines Isolators, der am Kühlkörper ausgebildete Hinterschnitte hintergreift, auf dem Metallblock befestigt. Durch den Isolator wird einerseits der Metallblock, der auf dem Potenzial der Sammelschiene liegt, welches mehr als 1.000 Volt betragen kann, abgedeckt, sodass eine unbeabsichtigte Berührung nicht vorkommen kann, und andererseits der Kühlkörper auf einfache Weise am Metallblock befestigt ist.

Als sehr vorteilhaft hat sich eine Ausführungsform der Erfindung herausgestellt, bei der eine Schaltungsanordnung zur Auswertung und Digitalisierung der von den Stromsensoren abgegebenen Signale vorhanden ist, die auf dem Potenzial der Sammelschiene liegt, wobei die digitalen Ausgangssignale der Schaltungsanordnung über eine Potenzialtrennung auf Ausgangsklemmen geführt sind. Dadurch, dass die Schaltungsanordnung auf dem Potenzial der Sammelschiene liegt, sind besondere Isolierungen bei der Schaltungsanordnung nicht erforderlich. Interne Isolationen können somit entfallen. Es ist lediglich eine Isolation der gesamten Vorrichtung erforderlich. Dies kann dadurch erreicht werden, dass die Leiterplatte auf der Oberseite vollständig abgedeckt ist und der gesamte Aufbau in einem Isolierstoffgehäuse eingebaut ist.

Bei einer bevorzugten Ausgestaltung der Erfindung ist zum Verbinden der Sammelschiene mit einem Anschlussleiter mindestens ein Anschlussbolzen an der Sammelschiene angeordnet, wobei der Anschlussbolzen zum Anklemmen des Anschlussleiters mit einer Klemmmutter verschraubbar ist, und wobei der Anschlussbolzen und/oder die Sammelschiene drehfest mit einer an dem Trägerteil abgestützten Drehmomentstütze verbunden ist. Ein beim Anziehen und/oder Lösen der Klemmmutter in den Anschlussbolzen eingeleitetes Drehmoment wird dann über die Drehmomentstütze direkt an dem Trägerteil abgestützt. Somit werden in die Leiterplatten beim Anziehen und/oder Lösen der Klemmmutter keine mechanischen Kräfte eingeleitet.

Vorteilhaft ist, wenn die Drehmomentstütze als im Wesentlichen parallel zur Leiterplatte angeordnete Stützplatte ausgestaltet ist, und wenn die Stützplatte Durchtrittslochungen für den mindestens einen Anschlussbolzen aufweist, welche den Anschlussbolzen drehfest mit der Stützplatte verbindet. Die Vorrichtung ermöglicht dadurch einen kompakten, aber dennoch mechanisch robusten Aufbau.

Die erfindungsgemäße Vorrichtung hat den großen Vorteil, dass mehrere Vorrichtungen auf einer gemeinsamen Sammelschiene angeordnet sein können. Die Sammelschiene kann dann bei der Montage der Vorrichtung mit der für die jeweilige Anwendung benötigten Anzahl von Modulen, die jeweils eine Leiterplatte mit daran angeordneten Anschlussklemmen, Stromsensoren und Kontaktstiften umfassen, bestückt werden.

Bei einer bevorzugten Ausgestaltung der Erfindung sind die Leiterplatten an einem Isolierstoffgehäuse oder dergleichen Trägerteil derart schwimmend gelagert, dass sie in Axialrichtung der Sammelschiene aufeinander zu- und voneinander wegbewegbar sind. Da jede Vorrichtung eine separate Leiterplatte aufweist, welche jeweils über Kontaktstifte mit der Sammelschiene verbunden sind, machen sich unterschiedliche Materialausdehnungen durch Wärme nicht bemerkbar. Sind auf der Sammelschiene beispielsweise nur etwa siebzig Millimeter breite Leiterplatten (Einzelmodule) angeordnet, wirken sich unterschiedliche Wärmeausdehnungen, welche bei einer Temperaturschwankung von beispielsweise minus zwanzig Grad Celsius bis plus fünfundachtzig Grad Celsius erheblich sein können, durch mittels der vorzugsweise mittig angeordneten Kontaktstifte jeweils separat vorgenommenen Verbindungen der Leiterplatten mit der Sammelschiene nahezu nicht aus. Eine Anordnung, welche beispielsweise bis zu sechzehn Leiterplatten aufweisen kann, bleibt aufgrund der schwimmenden Lagerung der Leiterplatten weitgehend kräftefrei. Der für die Ausdehnung der Leiterplatten erforderliche Platz ist leicht konstruktiv zu berücksichtigen. Die Kontaktstifte sind bevorzugt an einem räumlich begrenzten Teilbereich der Leiterplatte angeordnet, so dass bei einer durch Temperaturschwankungen verursachten Längenänderung der Sammelschiene zwischen den Kontaktstiften keine nennenswerten mechanischen Spannungen in den Leiterplatten auftreten.

Um zu vermeiden, dass die Sammelschiene an den Trennstellen der Leiterplatten zugänglich ist, weist die Sammelschiene in vorteilhafter Weise an den Trennstellen eine Ausnehmung auf, in der ein Isolierstreifen angeordnet ist.

Weitere Einzelheiten, Merkmale und Vorteile der vorliegenden Erfindung ergeben sich aus der nachfolgenden Beschreibung eines besonderen Ausführungsbeispiels unter Bezugnahme auf die Zeichnung.

Es zeigt:
- Fig. 1: eine perspektivische Ansicht eines ersten Ausführungsbeispiels einer zwei erfindungsgemäße Vorrichtung aufweisenden Anordnung in Explosionsdarstellung
- Fig. 2: eine perspektivische Ansicht einer in einem Gehäuseprofil eingebauten zwei erfindungsgemäße Vorrichtungen aufweisenden Anordnungen,
- Fig. 3: eine perspektivische Ansicht eines zweiten Ausführungsbeispiels einer mehrere erfindungsgemäße Vorrichtungen aufweisenden Anordnung, wobei die Anordnung teilweise im Querschnitt dargestellt ist, und
- Fig. 4: eine Ansicht auf die Stirnseite der in Fig. 3 gezeigten Anordnung.

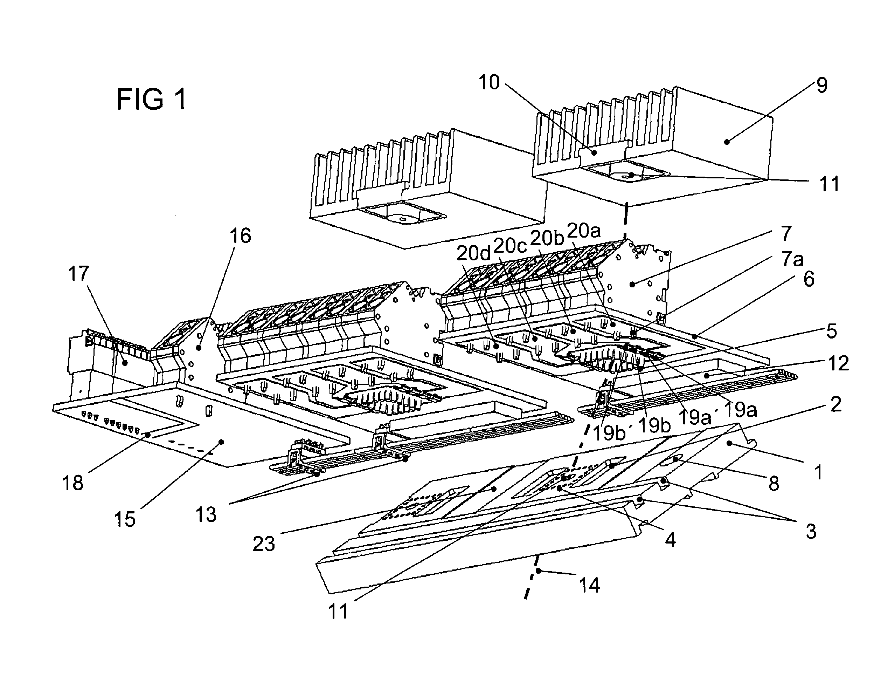

Wie Figur 1 entnommen werden kann, weist eine als zentraler Kupferleiter ausgebildete Sammelschiene 1 erste Ausnehmungen 2 sowie als Längsnut ausgebildete zweite Ausnehmungen 3 auf. Des Weiteren weist die Sammelschiene 1 als Bohrmuster angeordnete Verbindungsöffnungen 4 auf. Darüber hinaus weist die Sammelschiene 1 eine von den Verbindungsöffnungen 4 umgebene Durchgangsöffnung 11 sowie eine Bohrung 8 auf, zum Anschluss einer Ausgangsleitung für den in die Sammelschiene 1 eingeleiteten Gesamtstrom.

Oberhalb der Sammelschiene 1 sind zwei Multilayer-Leiterplatten 6 angeordnet, auf welchen jeweils acht Anschlussklemmen 7 angeordnet sind, zum Anschluss von Anschlussleitungen, mittels welcher zu überwachende Generatorströme einzelner Stränge von Photovoltaikanlagen an die Sammelschiene 1 geliefert werden. Jeweils zwei der Anschlussklemmen 7 sind parallel geschaltet, das heißt elektrisch miteinander verbunden. Die Anschlussklemmen 7 sind mittels Kontakten 7a, welche mit Leiterbahnen 20a, 20b, 20c, 20d verbunden sind, auf der Leiterplatte 6 befestigt. Die Kontakte 7 erstrecken sich bei auf der Sammelschiene 1 aufgesetzter Leiterplatte 6 in die zweiten Ausnehmungen 3 der Sammelschiene 1. Die Leiterbahnen 20a, 20b, 20c, 20d weisen jeweils drei Schichten der Multilayer-Leiterplatte 6 auf, welche Schichten jeweils an Verbindungen mit Bauelementen durchkontaktiert sind.

Die Leiterbahnen 20a, 20b, 20c, 20d sind an ihren den Anschlussklemmen 7 abgewandten Enden jeweils mit einem einen Stromeingang bildenden Anschluss von als Shunt 19a, 19a', 19b, 19b' ausgebildeten Stromsensoren verbunden. Die Shunts 19a, 19a', 19b, 19b' sind derart angeordnet, dass sie mit den ersten Ausnehmungen 2 der Sammelschiene 1 korrespondieren. Das heißt, bei auf der Sammelschiene 1 angeordneten Leiterplatten 6 erstrecken sich Shunts 19a, 19a', 19b, 19b' in die ersten Ausnehmungen 2. Zwei der Shunts, 19a, 19a' beziehungsweise 19b, 19b' sind jeweils mit einer Leiterbahn 20a beziehungsweise 20b verbunden, wodurch sie parallel geschaltet sind.

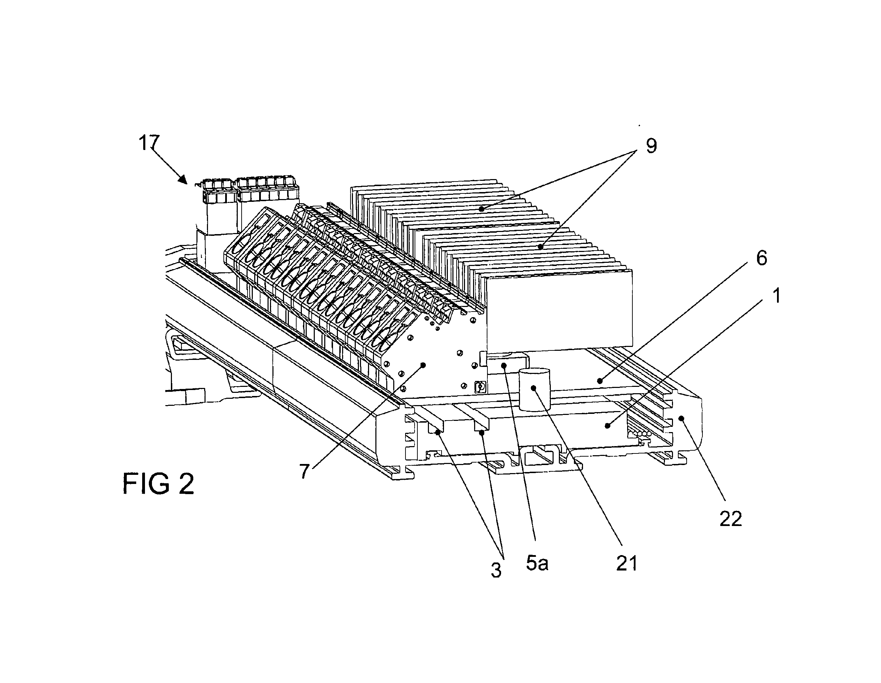

In der Mitte der Leiterplatte 6 ist eine rechteckförmige Anordnung von Öffnungen ausgebildet, durch welche sich Kontaktstifte 5 erstrecken. Die Kontaktstifte 5 sind aus einem Metallblock 5a herausgefräst, sodass sie einstückig mit dem Metallblock 5a ausgebildet sind. Hierdurch bilden die Kontaktstifte 5 eine stabile Anordnung, die sich auf einfache Weise in die Öffnungen der Leiterplatte 6 einbringen lässt. Des Weiteren besteht eine feste und stabile Verbindung der Kontaktstifte 5 mit der Leiterplatte 6. Die Anordnung des Metallblocks 5a auf der Leiterplatte 6 ist in Figur 2 dargestellt.

Die Kontaktstifte 5 sind derart angeordnet, dass sie mit den Verbindungsöffnungen 4 der Sammelschiene 1 korrespondieren. Das heißt, bei auf der Sammelschiene 1 aufgesetzten Leiterplatten 6 erstrecken sich die Kontakte 5 in die Verbindungsöffnungen 4. Die Verbindungsöffnungen 5 sowie die Kontaktstifte 5 sind derart bemessen, dass die Kontaktstifte 5 und die Verbindungsöffnungen 4 eine Pressverbindung bilden, wodurch eine feste Verbindung der Leiterplatte 6 mit der Sammelschiene 1 entsteht. Hierdurch sitzt die Leiterplatte 6 sicher auf der Sammelschiene 1.

Die einen Stromausgang bildenden Anschlüsse der Shunts 19a, 19a', 19b, 19b' sind mit dem Metallblock 5a und somit mit den Kontaktstiften 5 verbunden. Nachdem die Kontaktstifte 5 in die Verbindungsöffnungen 4 eingepresst sind, sind die Stromausgänge der Shunts 19a, 19a', 19b, 19b' somit mit der Sammelschiene 1 verbunden.

Die Sammelschiene 1 sowie der Metallblock 5a weisen miteinander korrespondierende Durchgangsöffnungen 11 auf, durch welche eine Schraube durchführbar ist. Mittels der Schraube lässt sich ein Isolator 10, der eine entsprechende Gewindebohrung 11a aufweist, auf dem Metallblock 5a befestigen. Der Isolator 10 hintergreift einen Hinterschnitt eines Kühlkörpers 9, wodurch der Kühlkörper 9 mittels des Isolators 10 mit der Leiterplatte 6 verbunden werden kann. Die Verbindungen sind mittels einer Verbindungslinie 14 angedeutet.

An den den Anschlussklemmen 7 gegenüberliegenden Enden der Leiterplatte 6 sind auf der den Anschlussklemmen 7 abgewandten Seite der Leiterplatte 6 elektronische Komponenten wie interne Buskontakte 13 eines internen Digitalbusses oder Komponenten 12 zur Digitalisierung der Strommessung angeordnet. Da sich die Auswertelektronik auf dem Potenzial der Sammelschiene 1 befindet, sind gegenüber der Sammelschiene 1 keine besonderen Maßnahmen zur Isolation erforderlich. Schaltungsintern sind keine Potenzialunterschiede über 5 Volt zu erwarten.

Unterhalb der Trennstellen der Leiterplatten 6 weist die Sammelschiene 1 eine Ausnehmung 23 auf, in der ein Isolierstoffstreifen angeordnet ist. Hierdurch ist die Sammelschiene 1 an der Trennstelle der Leiterplatten 6 nicht mehr zugänglich.

Die Anordnung weist des Weiteren eine weitere Leiterplatte 15 auf, auf der weitere elektronische Komponenten zur Auswertung der Sensorsignale angeordnet sind. Auf der weiteren Leiterplatte 15 sind des Weiteren Niederspannungs-Anschlussklemmen 17 angeordnet, zur Energieversorgung der elektronischen Auswerteschaltung sowie zum Anschluss des Feldbusses. Die Niederspannungs-Anschlussklemmen 17 sind über eine Potenzialtrennung, die in der Figur 1 schematisch durch einen Spalt 18 dargestellt ist, mit den betreffenden im übrigen Hochspannungsteil angeordneten Basis-Komponenten verbunden.

Im Hochspannungsteil der weiteren Leiterplatte 15 ist des Weiteren eine Klemme 16 angeordnet, die den gemeinsamen Anschluss für die an die Anschlussklemmen 7 angeschlossenen Stränge der Photovoltaikanlage bildet.

Wie Figur 2 entnommen werden kann, lässt sich die Sammelschiene 1 sehr gut in einem Gehäuse 22 anordnen, welches für eine Hutschienenmontage geeignet ist. Das Gehäuse 22 besteht aus einem temperaturfesten Isolierstoff. Das Gehäuse 22 ist an beiden Seiten mit einer ebenfalls aus einem temperaturfesten Isolierstoff bestehenden Abschlussplatte versehen. Diese sind jedoch in Figur 2 aus Gründen der Übersichtlichkeit nicht dargestellt.

Wie Figur 2 erkennbar ist, weist das Gehäuse 22 einander gegenüberliegende Seitenwände auf, die an ihren einander zugewandten Innenseiten mit Nuten versehen sind, die sich in Axialrichtung der Sammelschiene 1 erstrecken. Zwischen diesen Nuten sind die Leiterplatten 6, 15 in Axialrichtung der Sammelschiene 1 aufeinander zu- und voneinander weg verschiebbar gehalten. Die Leiterplatten 6, 15 sind zu diesem Zweck in Axialrichtung der Sammelschiene 1 etwas voneinander beabstandet, so dass sie sich bei einer durch Temperaturschwankungen verursachten Längenänderung der Sammelschiene 1 relativ zueinander bewegen können, ohne dass mechanische Spannungen in die Leiterplatten 6, 15 eingeleitet werden.

Der Abgriff des Stromes von der Sammelschiene 1 erfolgt über mindestens einen Anschlussbolzen 21, der in die Bohrung 8 der Sammelschiene 1 eingebracht wurde. Der Anschlussbolzen 21 sowie der betreffende Bereich der Sammelschiene 1 wird von einer Abdeckung aus Isolierstoff umgeben. Mittels der Abdeckung wird auch ein an den Anschlussbolzen 21 angeschlossener Kabelschuh sowie eine zugehörige Scheibe und Mutter vor Berührung geschützt.

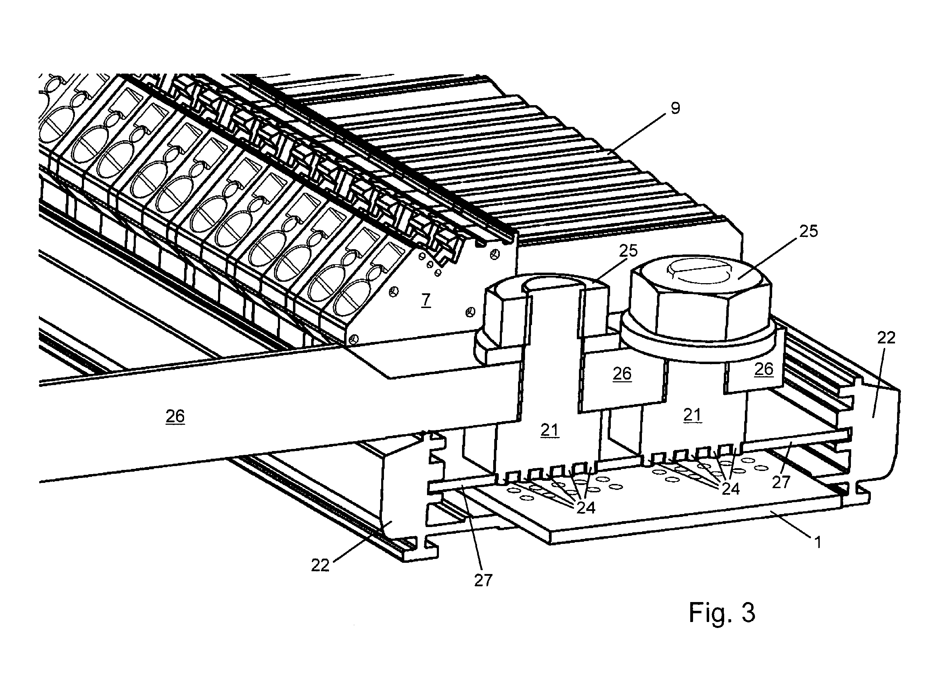

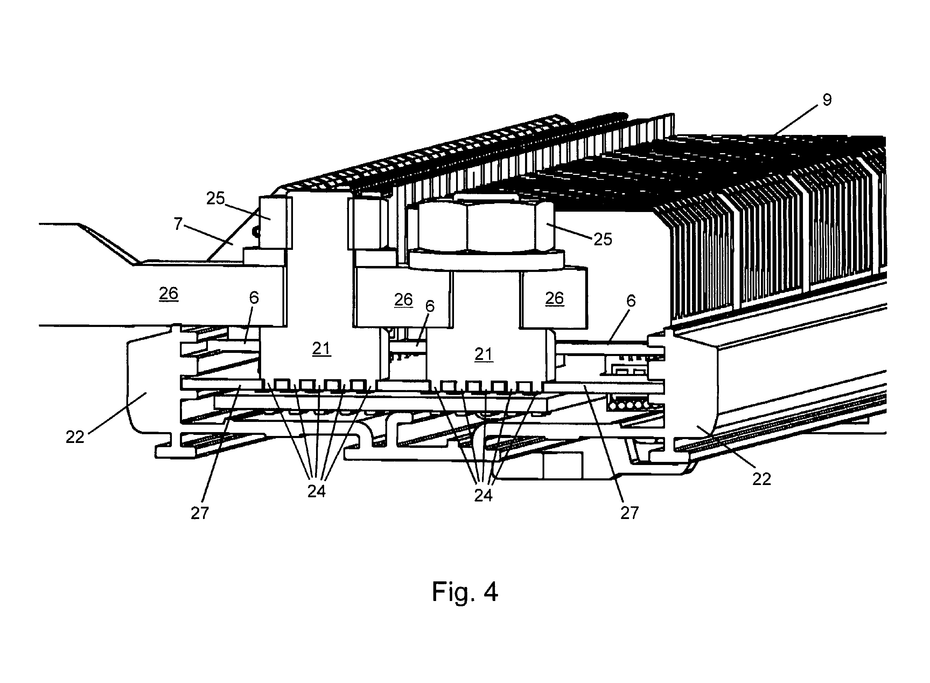

Bei dem in Fig. 3 und 4 gezeigten Ausführungsbeispiel weist die Vorrichtung zwei Anschlussbolzen 21 auf, die jeweils an einer der Sammelschiene 1 zugewandten Montagefläche mehrere stiftförmige Vorsprünge 24 haben, die in dazu passende Lochungen der Sammelschiene 1 eingepresst sind.

Benachbart zu der Leiterplatte 6 weist der Anschlussbolzen 21 eine Querschnittserweiterung mit einer Anlagefläche für einen Anschlussleiter 26 auf. Der Anschlussleiter 26 erstreckt sich quer zu der Sammelschiene 1 und verläuft im Wesentlichen parallel zu der Ebene, in der die Leiterplatten 6 angeordnet sind.

Der Anschlussleiter 26 hat für jeden Anschlussbolzen 21 eine Montageöffnung, die der betreffende Anschlussbolzen 21 durchsetzt. An seinem von den Vorsprüngen 24 entfernten freien Ende hat der Anschlussbolzen 21 ein Außengewinde, auf das eine Klemmmutter 25 derart aufgeschraubt ist, dass ein die Montageöffnungen umgrenzender Randbereich des Anschlussleiters 26 zwischen der Klemmmutter 25 und der Anlagefläche des Anschlussbolzens 21 eingespannt ist.

Wie in Fig. 3 und 4 erkennbar ist, sind die Anschlussbolzen 21 jeweils drehfest mit einer am Gehäuse 22 abgestützten Drehmomentstütze 27 verbunden. Die Drehmomentstütze 27 ist als parallel zu den Leiterplatten 6 verlaufende Stützplatte ausgestaltet, die Durchtrittsöffnungen aufweist, welche die stiftförmigen Vorsprünge 24 der Anschlussbolzen 21 derart durchsetzen, dass die Anschlussbolzen 21 bezüglich ihrer Längsachse drehfest mit der Drehmomentstütze 27 verbunden sind. Die Drehmomentstütze 27 ist zwischen einander zugewandten, in die Innenwandungen der Seitenwände des Gehäuses 22 eingelassen Nuten gehalten, so dass ein über die Klemmmutter 25 in den Anschlussbolzen 21 eingeleitetes Drehmoment über die Drehmomentstütze 27 gegen die Seitenwände des Gehäuses 22 abgestützt wird.

## Patentansprüche

1. Vorrichtung zur Überwachung von in Anschlussleitungen eingespeisten Strömen, insbesondere zur Überwachung von Generatorströmen, insbesondere von Photovoltaikanlagen, mit Anschlussklemmen (7), an welche die Anschlussleitungen anklemmbar sind, und welche über Stromsensoren (19a, 19a', 19b, 19b'), welche einen Stromeingang und einen Stromausgang für den zu überwachenden Strom haben, mit einer Sammelschiene (1) verbunden sind,
**dadurch gekennzeichnet,**
**dass** die Anschlussklemmen (7) auf einer Leiterplatte (6) angeordnet sind, auf welcher die Stromsensoren (19a, 19a', 19b, 19b') sowie Kontaktstifte (5) angeordnet sind, welche einerseits mit der Sammelschiene (1) und andererseits mit den Stromausgängen der Stromsensoren (19a, 19a', 19b, 19b') verbunden sind, wobei die Stromeingänge der Stromsensoren (19a, 19a', 19b, 19b') über wenigstens einen ersten auf der Leiterplatte (6) angeordneten Leiter (20a, 20b, 20c, 20d) mit den Anschlussklemmen (7) verbunden sind und die Verbindung der Stromausgänge der Stromsensoren (19a, 19a', 19b, 19b') mit den Kontaktstiften (5) über wenigstens einen zweiten auf der Leiterplatte (6) angeordneten Leiter erfolgt.

2. Vorrichtung nach Anspruch 1,
**dadurch gekennzeichnet,**
**dass** die Leiterplatte (6) als ein Multilayer-Leiterplatte ausgebildet ist und der erste und/oder der zweite Leiter (20a, 20b, 20c, 20d) aus mehreren Schichten der Multilayer-Leiterplatte (6) bestehen.

3. Vorrichtung nach Anspruch 1 oder 2,
**dadurch gekennzeichnet,**
**dass** die Kontaktstifte (5) in in der Sammelschiene (1) ausgebildete Verbindungsöffnungen (4) eingepresst sind.

4. Anordnung nach Anspruch 1 oder 2,
**dadurch gekennzeichnet,**
**dass** der mindestens eine auf der Leiterplatte angeordnete Kontaktstift (5) einstückig mit einem Kontaktabschnitt verbunden ist, und dass der Kontaktabschnitt mit der Sammelschiene (1) verschraubt ist.

5. Vorrichtung nach einem der Ansprüche 1 bis 4,
**dadurch gekennzeichnet,**
**dass** die Kontaktstifte (5) sich aus einem Metallblock (5a) erstrecken.

6. Vorrichtung nach einem der Ansprüche 1 bis 5,
**dadurch gekennzeichnet,**
**dass** jeweils zwei Stromsensoren (19a, 19a' beziehungsweise 19b, 19b') parallel geschaltet sind.

7. Vorrichtung nach einem der Ansprühe 1 bis 6,
**dadurch gekennzeichnet,**
**dass** die Sammelschiene (1) Ausnehmungen (2) aufweist, in die sich die Stromsensoren (19a, 19a', 19b, 19b') erstrecken.

8. Vorrichtung nach einem der Ansprüche 4 bis 7,
**dadurch gekennzeichnet,**
**dass** der Metallblock (5a) sowie die Sammelschiene (1) miteinander korrespondierende Durchgangsöffnungen (11) aufweisen, durch welche eine Schraube durchführbar ist, mittels der ein Isolator (10) auf den Metallblock (5a) befestigbar ist.

9. Vorrichtung nach Anspruch 8,
**dadurch gekennzeichnet,**
**dass** ein Kühlkörper (9) mittels des Isolators (10), der am Kühlkörper (9) ausgebildete Hinterschnitte hintergreift, befestigbar ist.

10. Vorrichtung nach einem der Ansprüche 1 bis 9,
**dadurch gekennzeichnet,**
**dass** eine Schaltungsanordnung zur Auswertung der von den Stromsensoren (19a, 19a', 19b, 19b') abgegebenen Signale vorhanden ist, welche auf dem Potenzial der Sammelschiene (1) liegt, und deren Ausgangssignale über eine Potenzialtrennung (18) auf Ausgangsklemmen (17) geführt sind.

11. Vorrichtung nach einem der Ansprüche 1 bis 10,
**dadurch gekennzeichnet,**
**dass** die Sammelschiene (1) eine Ausnehmung (23) aufweist, in der ein Streifen aus Isolierstoff angeordnet ist.

12. Vorrichtung nach einem der Ansprüche 1 bis 10,
**dadurch gekennzeichnet,**
**dass** zum Verbinden der Sammelschiene (1) mit einem Anschlussleiter mindestens ein Anschlussbolzen (21) an der Sammelschiene (1) angeordnet ist, dass der Anschlussbolzen (21) zum Anklemmen des Anschlussleiters mit einer Klemmmutter verschraubbar ist, und dass der Anschlussbolzen (21) und/oder die Sammelschiene (1) drehfest mit einer an dem Trägerteil abgestützten Drehmomentstütze verbunden ist.

13. Vorrichtung nach Anspruch 12,
**dadurch gekennzeichnet,**
**dass** die Drehmomentstütze als im Wesentlichen parallel zur Leiterplatte angeordnete Stützplatte ausgestaltet ist, und dass die Stützplatte wenigstens eine Durchtrittslochungen für den mindestens einen Anschlussbolzen aufweist, welche den Anschlussbolzen drehfest mit der Stützplatte verbindet.

14. Anordnung zur Überwachung von in Anschlussleitungen eingespeisten Strömen, insbesondere zur Überwachung von Generatorströmen, insbesondere von Photovoltaikanlagen,
**dadurch gekennzeichnet,**
**dass** sie mehrere Vorrichtungen nach einem der Ansprüche 1 bis 13 aufweist, wobei die Leiterplatten (6) separat ausgebildet, jedoch mit einer gemeinsamen Sammelschiene (1) verbunden sind.

15. Anordnung nach Anspruch 14,
**dadurch gekennzeichnet,**
**dass** die Leiterplatten (6) an einem Isolierstoffgehäuse oder dergleichen Trägerteil derart schwimmend gelagert sind, dass sie in Axialrichtung der Sammelschiene (1) aufeinander zu- und voneinander wegbewegbar sind.
